# FASCICULE DE BREVET EUROPEEN

(11) **EP 2 356 511 B1**
(45) Date de publication et mention de la délivrance du brevet: **17.06.2015**
(21) Numéro de dépôt: 09755910.8
(22) Date de dépôt: 19.11.2009
(51) Int. Cl.: G02F 2/00, H03L 7/04, H01S 3/13

(54) **Discriminateur de fréquence opto-électronique accordable en fréquence**
Durchstimmbarer optoelektronischer Frequenz-Diskriminator
Frequency-adjustable optoelectronic frequency discriminator

(30) Priorité: 28.11.2008 FR 0806702
(43) Date de publication de la demande: 17.08.2011
(73) Titulaire: THALES, 92200 Neuilly-sur-Seine (FR)
(72) Inventeur: PILLET, Grégoire, F-75013 Paris (FR); MORVAN, Loïc, F-91400 Orsay (FR); DOLFI, Daniel, F-91400 Orsay (FR)
(74) Mandataire: Esselin, Sophie
(86) Numéro de dépôt international: PCT/EP2009/065503
(87) Numéro de publication internationale: WO 2010/060859

(56) Documents cités:
- EP-A- 0 523 921
- EP-B- 0 861 513
- WO-A-00/17613
- GREGOIRE PILLET ET AL: "Stabilization of the beatnote of a 1.5m dual-frequency laser using a fiber-optic delay line" LASERS AND ELECTRO-OPTICS, 2007 AND THE INTERNATIONAL QUANTUM ELECTRON ICS CONFERENCE. CLEOE-IQEC 2007. EUROPEAN CONFERENCE ON, IEEE, PI, 1 juin 2007 (2007-06-01), pages 1-1, XP031162263 ISBN: 978-1-4244-0930-3
- LOGAN R T JR ET AL: "Stabilization of oscillator phase using a fiber-optic delay-line" FREQUENCY CONTROL, 1991., PROCEEDINGS OF THE 45TH ANNUAL SYMPOSIUM ON LOS ANGELES, CA, USA 29-31 MAY 1991, NEW YORK, NY, USA,IEEE, US, 29 mai 1991 (1991-05-29), pages 508-512, XP010040174 ISBN: 978-0-87942-658-3

## Description

Le domaine de l'invention est celui des dispositifs opto-électroniques permettant de mesurer et/ou d'asservir et/ou de balayer la différence de fréquence entre deux sources laser.

Ce type de dispositif est notamment utilisé pour des applications comme :
- la génération de faisceaux laser modulés en intensité à haute pureté spectrale et accordable en fréquence (par exemple pour la génération d'horloges ou d'oscillateurs locaux optiques, la génération de forme d'onde pour lidars, ...) ;
- la génération de signaux électriques à haute pureté spectrale et accordable en fréquence (par exemple pour la génération d'horloges ou d'oscillateurs locaux électroniques, la génération de forme d'onde pour radars à haute résolution...) ;
- la détection optique cohérente hétérodyne (par exemple pour les lidars cohérents...) ;
- la génération d'onde optique fine spectralement et accordable en fréquence (spectroscopie...).

Il est connu d'utiliser des discriminateurs de fréquence opto-électroniques pour les applications pré-citées.

Les sources basées sur ce type de boucle ont l'avantage de présenter des très grandes finesses, de la stabilité, de la compacité et de la robustesse en alliant l'avantage des composants optiques (ligne à retard en fibre optique, filtres, déphaseurs optiques large bande, amplificateurs large bande...) et électroniques (amplificateurs faibles bruit, mélangeurs hyperfréquences...), comme décrit notamment dans le brevet US Patent 5,687,261, 11/11/1997.

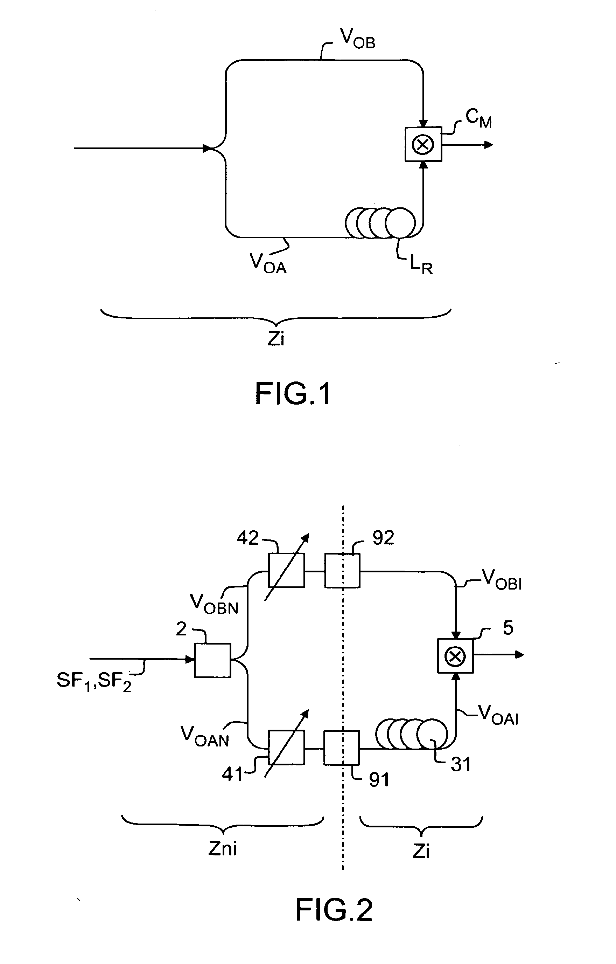

Dans ce type de dispositif on cherche à déterminer et/ou asservir la différence de fréquence (modulo une certaine ambiguïté) entre deux ondes optiques (correspondant à un couple d'ondes optiques). La détermination de la différence de fréquence est réalisée à l'aide d'un discriminateur de fréquence opto-électronique. Ce dernier prend en entrée le couple d'ondes optiques en condition d'interférence (c'est-à-dire que les deux ondes coïncident alors en partie spatialement et en polarisation). Il sépare le couple d'ondes optiques dans deux bras d'un interféromètre (les deux ondes sont présentes dans les deux bras). Une telle configuration est notamment illustrée en figure 1, une voie V_{OA} et une voie V_{OB} portent le couple des deux ondes qui coïncident spatialement et en polarisation.

Durant l'ensemble de la propagation dans chaque bras les deux ondes optiques sont en condition d'interférence. Du fait de cette condition d'interférence, on observe alors tout le long de la propagation une modulation d'intensité à une fréquence de battement (définissant donc une phase de battement) correspondant à la différence de fréquence entre les deux ondes.

De plus, l'un des deux bras est retardé (délai τ) à l'aide d'une ligne à retard optique L_{R}. Une comparaison de phase du battement à l'extrémité des deux bras est ensuite réalisée par un comparateur C_{M} (plusieurs architectures mêlant composants optiques et électroniques sont envisageables pour cette comparaison). En sortie de l'interféromètre on obtient un signal optique ou électrique S(Δφ) où S est une fonction de Δφ, où Δφ est la différence de phase des battements entre les deux bras d'interférence.

Dans le cas ou la fréquence de battement f varie lentement pendant le délai τ on peut montrer que la différence de phase de battement est proportionnelle à la fréquence de battement suivant la relation Δφ=2πfτ. On obtient ainsi en sortie de l'interféromètre un signal (optique ou électrique) dépendant de la fréquence de battement. On a donc S(Δφ)=S(2πfτ) et S est nécessairement périodique modulo 2π.

Toute variation de fréquence de battement se traduit alors par une variation du signal de sortie. Cette variation est susceptible d'être d'autant plus forte que le délai τ est grand (la dérivée de S par rapport à f est proportionnelle à τ). C'est pourquoi l'utilisation de longs retards en fibre optique présente un très grand intérêt pour améliorer la finesse spectrale de la mesure et/ou de la source asservie sur le signal de l'interféromètre.

Néanmoins, la grande finesse spectrale résultante est à pondérer par l'existence de « fréquences aveugles ». En effet, on ne peut pas mesurer avec ce dispositif les variations de fréquence autour de certaines fréquences du fait de la périodicité de la fonction S. En effet, en supposant que S est indéfiniment dérivable en fonction de φ, on peut montrer mathématiquement que du fait de sa périodicité, sa dérivée première s'annule nécessairement une fois dans chaque intervalle [0, 2 π] + 2k π (avec k entier relatif).

Ainsi quel que soit k entier relatif, il existe Δφₖ dans l'intervalle [0, 2 π] + 2k π, tel que la dérivée de S en Δφₖ est nulle. Ceci correspond à un ensemble de fréquences aveugles fₖ vérifiant Δφ_{κ}=2πfₖτ.

Des méthodes pour accorder en fréquence, un discriminateur de fréquence, c'est-à-dire pour changer les positions des fréquences aveugles, sont explorées dans le brevet US Patent 5,204,640 20/04/1993. Elles utilisent des modulateurs de délai (soit par voie optique, soit par voie électrique après détection du battement à l'extrémité d'un bras) sur l'un des deux bras. Ces modulateurs de délai permettent d'accorder le délai τ de l'interféromètre et donc de modifier les fréquences aveugles fₖ. Il est notamment proposé d'utiliser un élément piézoélectrique permettant de faire varier un délai en fibre optique, mais ce type de solution implique des faibles accordabilités et/ou des temps de réaction encore longs et donc incompatibles avec des applications dans le domaine des sources hyperfréquences largement et/ou rapidement accordables par exemple.

Le document WO 00/17613 A décrit un détecteur de phase optique. L'article de G. Pillet et al. : « Stabilization of the beatnote of a 1.5m dual-frequency laser using a fiber-optic delay line », Laser and Electro-optics, 2007 and The international Quantum Electron ICS Conference (CLEOE-IQEC 2007), 1 juin 2007, page 1, divulgue un dispositive opto-électronique de discrimination de fréquence. Le préambule de la revendication 1 se fonde sur l'article précité.

Dans ce contexte la présente invention a pour objet un dispositif opto-électronique permettant une accordabilité très large et/ou très rapide en fréquence.

Plus précisément l'invention a pour objet un dispositif opto-électronique de discrimination de fréquence tel que défini dans la revendication 1.

Selon une variante de l'invention, le discriminateur comprend des moyens pour utiliser le signal en sortie dudit disciminateur pour réaliser un asservissement de la première et/ou la seconde fréquence à partir dudit signal électronique comparateur.

Selon une variante de l'invention, les moyens pour générer un délai supplémentaire sont présents sur un des premier ou second bras.

Selon une variante de l'invention, le dispositif comprend des premiers moyens pour générer un délai supplémentaire, présents sur le premier bras et des seconds moyens pour générer un délai supplémentaire présents sur le second bras.

Selon une variante de l'invention, les moyens pour générer un délai supplémentaire comprennent un élément piézoélectrique permettant de changer la longueur d'une ligne à retard en fibre optique.

Selon une variante de l'invention, les moyens pour générer un délai supplémentaire comprennent un élément piezoélectrique permettant de changer la longueur d'une ligne à retard en espace libre.

Selon une variante de l'invention, les moyens pour générer un délai supplémentaire comprennent un modulateur de phase sur au moins l'un des bras.

Selon une variante de l'invention, les moyens pour générer un délai supplémentaire comprennent un élément à biréfringence accordable.

Selon une variante de l'invention, le premier et/ou le second bras comprennent en outre un polariseur.

Selon une variante de l'invention, les moyens opto-électroniques pour comparer lesdites première et seconde phases de battement des deux extrémités de bras fournissant un signal électronique ou optique comportent un comparateur de phase de modulation.

Selon une variante de l'invention, le comparateur de phase de modulation comprend deux photodiodes recevant chacune le signal provenant de chacun des premier et second bras et un mélangeur électronique.

Selon une variante de l'invention, les moyens pour générer un délai supplémentaire accordable sur l'un des premier ou second bras sont fibrés.

L'invention sera mieux comprise et d'autres avantages apparaîtront à la lecture de la description qui va suivre donnée à titre non limitatif et grâce aux figures annexées parmi lesquelles :
- la figure 1 illustre un exemple de discriminateur de fréquence opto-électronique selon l'art connu ;
- la figure 2 illustre un exemple utile pour comprendre le principe général de l'invention pour un discriminateur de fréquence utilisant un délai supplémentaire sur au moins un des deux bras ;
- la figure 3 illustre un exemple utile pour comprendre l'invention pour laquelle les deux ondes optiques en entrée du disciminateur ont des polarisations orthogonales, le délai supplémentaire étant appliqué avec des moyens biréfringents ;
- la figure 4 illustre un exemple utile pour comprendre l'invention pour laquelle les deux ondes optiques en entrée du disciminateur ont des polarisations orthogonales, le délai supplémentaire étant appliqué après séparation des deux polarisations ;
- la figure 5 illustre un mode de réalisation de l'invention pour lequel les deux ondes optiques en entrée du disciminateur ne coïncident pas spatialement, le délai supplémentaire étant appliqué avant mise en coïncidence spatiale des deux ondes ;
- la figure 6 illustre une variante, applicable au mode de réalisation de l'invention, dans laquelle le signal en sortie du discriminateur est utilisée pour réaliser une boucle d'asservissement à verrouillage de fréquence ;
- la figure 7 illustre le signal de sortie récupéré au niveau du comparateur de phase (dans le cas ou le comparateur à une réponse sinusoïdale) et ce en fonction de la fréquence de battement F₁-F₂ dans un discriminateur de fréquence selon l'invention ;
- les figures 8a et 8b illustrent respectivement la biréfringence en fonction du temps, la biréfringence étant traduite par une tension appliquée au composant à modulation de phase et les fréquence de battement correspondantes dans le cas où le discriminateur de fréquence selon l'invention est associé à une boucle à verrouillage de fréquence ;
- la figure 9 détaille l'évolution en fonction du temps de la fréquence de battement correspondant au même type de fonction que celle illustrée en figure 8b et ce pour un exemple précis de discriminateur.

De manière générale, le discriminateur de fréquence est alimenté par deux ondes optiques pouvant typiquement être émises par deux lasers émettant respectivement des ondes optiques à des fréquences F₁ et F₂ ou par un laser bifréquence émettant deux ondes optiques de polarisations orthogonales l'une par rapport à l'autre.

La figure 2 illustre un schéma général utile pour comprendre la présente invention. Des moyens pouvant être de type laser délivrent deux ondes optiques S_{F1} et S_{F2} appelée paire ou couple d'ondes optiques.

Les deux ondes optiques en entrée du discriminateur sont en situation de non-interférence.

Le discriminateur de fréquence comporte des moyens 2 pour séparer en un premier et un second bras les paires d'ondes optiques. Les deux bras définissant une première et une seconde voies optiques V_{OA} et V_{OB}.

Le premier et le second bras incluent chacun un élément 91 et 92 (typiquement un polariseur, un miroir ou un coupleur) pour s'assurer que les deux bras se terminent par une zone d'interférence.

Nous appelerons la partie de V_{OA} (resp. V_{OB}) amont de cet élément V_{OAN} (reps. V_{OBN}) et la partie aval de cet élément V_{OAI} (reps. V_{OBI}).

La voie optique V_{OA}, et/ou V_{OBI} comporte des moyens 31 (et/ou 32 non représentés) pour générer un délai sur l'un des deux bras, typiquement il peut s'agir d'une ligne à retard.

Selon l'invention, il est proposé d'introduire un délai supplémentaire sur l'une ou l'autre des ondes optiques d'un bras en zone de non interférence V_{OAN} et/ou V_{OBN}, par des moyens 41 et/ou 42 dédiés à cet effet, ce délai étant par ailleurs accordable.

Ces moyens 41 et/ou 42 sont prévus pour générer un délai supplémentaire accordable sur l'une des première ou seconde ondes optiques de la paire d'onde d'un bras.

Le dispositif opto-électronique de l'invention comporte également des moyens opto-électroniques 5 pour comparer lesdites première et seconde phase de battement en fin des deux bras fournissant un signal électronique ou optique comparateur.

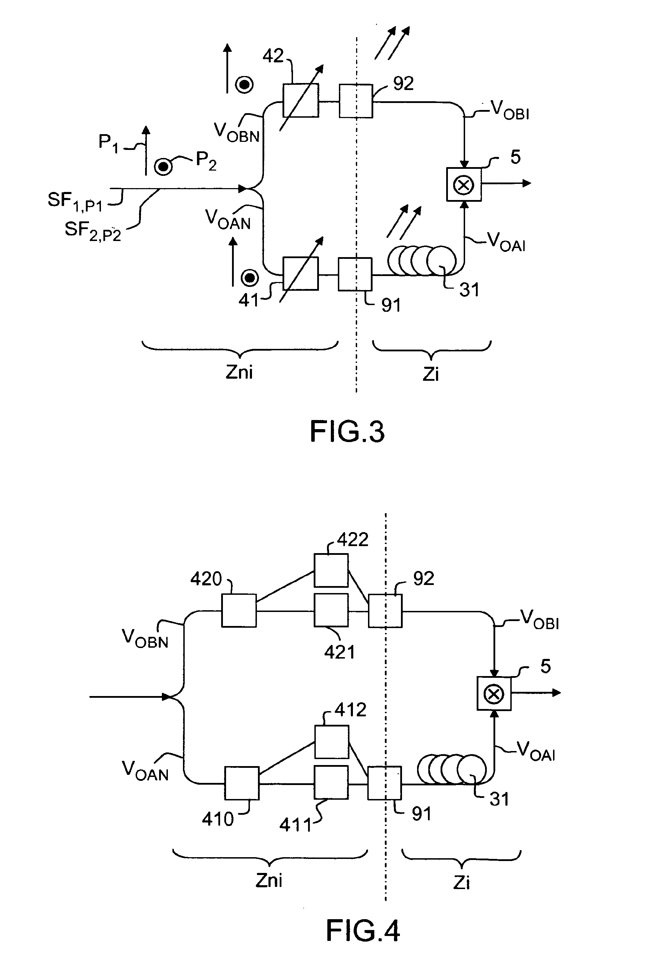

Selon un exemple décrit en détails ci-après, le discriminateur de fréquence accordable est utilisé avec deux ondes optiques injectées dans la même fibre optique et polarisées orthogonalement S_{F1,P1} et S_{F2,P2} comme illustré en figure 3. Cet exemple ne tombe pas sous l'invention.

Le principe de cet exemple en est le suivant :
Les deux polarisations orthogonales sont injectées dans le discriminateur selon le même axe de propagation. Nous sommes alors bien en condition de non interférence du fait que les deux ondes sont polarisées orthogonalement. Les deux bras comportent un composant biréfringent 41 et 42 dont la biréfringence est ajustable, il peut s'agir typiquement d'un modulateur de phase électro-optique (il est à noter que seule une des voies pourrait aussi comprendre un modulateur de phase électro-optique).

Dans chacun des deux bras V_{OA} et V_{OB}, les deux ondes sont ensuite projetées sur le même état de polarisation, à l'aide d'un polariseur ou d'un élément séparateur de polarisation 91, 92 afin de définir en amont les zones de non interférence V_{OAN} et V_{OBN} et en aval les zones d'interférence V_{OAI} et V_{OBI}.

De la même manière que précédemment une comparaison de la phase de battement est ensuite réalisée par un composant 5.

La phase de battement de la voie comportant le composant biréfringent est décalé proportionnellement à la biréfringence ce qui permet d'obtenir une accordabilité des fréquences aveugles.

Dans le cas représenté en figure 3, les phases de battement peuvent être décalées différemment permettant une latitude supplémentaire.

Les avantages de cet exemple sont les suivants :
- la biréfringence peut être induite par des composants optiques fibrés standards ;
- le délai induit est peu dépendant de la fréquence de battement mais ne dépend que de la fréquence optique ce qui rend le composant très large bande ;
- la bande passante d'accordabilité peut être très grande (notamment avec les modulateurs de phase en niobate de lithium qui répondent en quelques dizaines de picosecondes) et permet ainsi d'envisager des accordabilité en fréquence rapides et contrôlés ;
- l'efficacité peut être très grande (notamment avec les modulateurs de phase en niobate de lithium qui déphasent de 2π avec quelques volts).

L'architecture proposée peut être une architecture entièrement fibrée. Il peut être avantageux d'utiliser une architecture à maintien de polarisation au moins jusqu'à l'élément polarisant.

La figure 4 illustre une variante de l'exemple précédent utilisant des éléments polarisants pouvant être des cubes séparateurs de polarisation. Plus précisément selon cette variante, les deux polarisations sont séparées dans au moins un des deux bras avant application du délai supplémentaire (par les moyens 411, 412, 421 et/ou 422) sur au moins une des deux ondes optiques d'au moins un des deux bras. Le discriminateur comprend des cubes séparateurs 410 et 420 orientés suivant les deux polarisations orthogonales de manière à séparer les deux ondes optiques, dans la zone de non-interférence Zni et des moyens pour recombiner les deux ondes optiques dans chaque bras selon le même axe de propagation et selon la même polarisation.

Ces moyens correspondent aux composants 91 et 92 à partir desquels sont créées les interférences. Ces derniers moyens peuvent dans ce cas être composés de lame d'onde, de cube combineur de polarisation, de polariseur et/ou de coupleur.

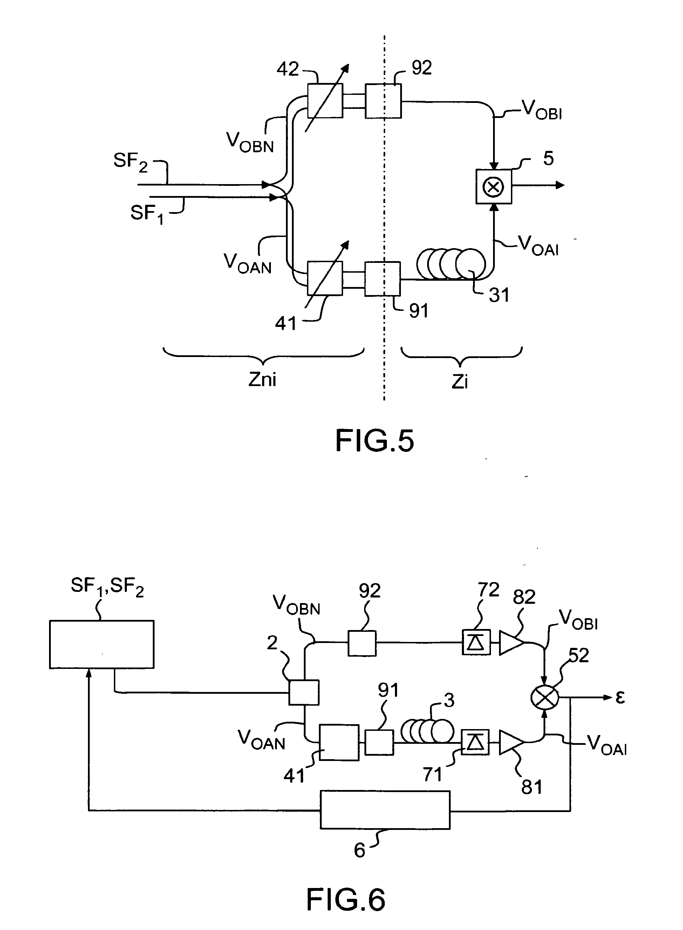

Selon l'invention, les deux ondes optiques en entrée du disciminateur ne coïncident pas spatialement, le délai supplémentaire étant appliqué avant mise en coïncidence spatiale des deux ondes comme illustré en figure 5 qui met en évidence le décalage spatial desdites ondes optiques.

La figure 6 illustre plus en détails les composants utilisés dans une variante de discriminateur de fréquence applicable au mode de réalisation en figure 5 dans lequel un seul des bras comprend un composant à modulation de délai accordable, les deux ondes en entrée étant polarisées orthogonalement, et l'architecture étant fibrée, une boucle de rétroaction étant utilisée pour asservir les deux ondes optiques et les deux ondes optiques étant générées par un laser bifréquence. Quand la variante en Figure 6 est appliquée au discriminateur en figure 5, les ondes en entrée sont séparées; en outre, un décalage spatiale est crée entre elles.

Les deux bras V_{OAN} et V_{OBN} du discriminateur sont issus de la même paire d'onde en utilisant un coupleur optique 2 , 50/50.

En sortie des deux bras V_{OAI} et V_{OBI}, le comparateur de phase de battement peut être composé de deux photodiodes 71 et 72 recevant chacune le signal provenant de chacun des bras en zone d'interférence couplées à des amplificateurs 81 et 82 et alimentant un mélangeur électronique 51 de type multiplicateur fournissant un signal électronique ε.

Le signal électronique ε est injecté dans une boucle d'asservissement.

La boucle d'asservissement peut quant à elle avantageusement comprendre un filtre électronique basse fréquence 6.

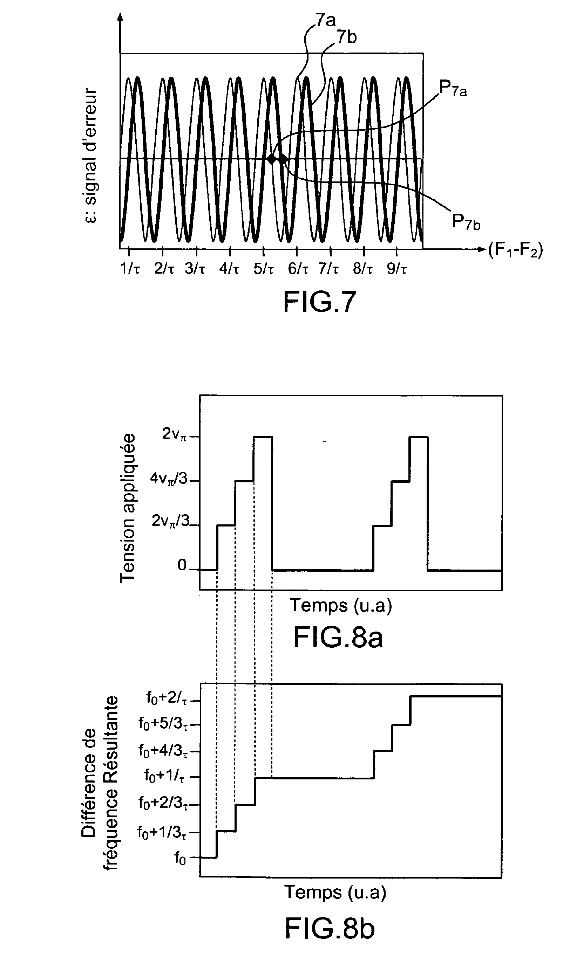

La figure 7 illustre l'intérêt d'accorder la biréfringence du discriminateur. Elle fournit le signal de sortie récupéré au niveau du mélangeur et ce en fonction de la fréquence de battement F₁-F₂ pour deux délais supplémentaires différents appliqués sur une des deux ondes de la voie B.

La courbe 7a est relative au résultat obtenu avec un discriminateur de fréquence de l'art antérieur qui avec une ligne à retard sur un des bras introduit un délai identique pour les deux ondes optiques. Elle correspond aussi à un discriminateur selon l'invention dans le cas ou le (les) délais supplémentaires sont nuls.

Le signal en sortie du discriminateur est périodique en fonction de la différence de fréquence des deux ondes optiques en entrée du discriminateur.

A un signal de sortie correspond un ensemble infini de différences de fréquence espacées de 1/τ. Cette périodicité est génante pour réaliser un asservissement accordable en fréquence continuement : l'asservissement est impossible lorsque que l'on choisit la tension de consigne aux environs des points où la réponse du discriminateur de fréquence est quadratique en fonction de la fréquence d'entrée (sommets).

La courbe 7b est relative à un discriminateur de l'invention. La biréfringence permet de changer la phase de la périodicité et ainsi de déplacer la fréquence asservie d'une zone à l'autre sans changer les tensions de consigne ni la réponse linéaire de l'interféromètre réalisé par les deux voies optiques. Il est à noter que le passage du point P₇ₐ au point P_{7b} peut être continu.

On peut utiliser l'ambiguité de 2π de la phase pour réaliser des balayages de fréquence arbitrairement grands sans pour autant utilser de tension de commande élevée (méthode incrémentale).

L'intérêt de réaliser des pas de 1/τ est que la tension de commande pour chaque pas de fréquence est identique. Ceci signifie que seule une caractérisation non affinée du paramètre v_{π} du modulateur de phase est nécessaire.

Les figures 8a et 8b sont relatives à un exemple de fonction de biréfringence applicable dans le cadre de l'invention.

La figure 8a illustre un exemple de biréfringence en fonction du temps (indiqué en unité arbitaire a.u) que l'on peut choisir pour changer une fréquence de battement asservie f₀ et simuler des déphasages supérieurs à 2π, la biréfringence étant traduite par une tension appliquée au composant à modulation de phase accordable.

La figure 8b illustre la réponse en terme de fréquence de battement résultante en correspondance avec la figure 8a.

L'ambiguité de 2π sur la phase permet de réaliser des balayages en fréquence de battement sur plus de 1/τ sans pour autant nécessiter de tensions de commande supérieures à v_{2π}.

### Exemple de discriminateur de fréquence

Exemple de fréquence F1 et de fréquence F2 utlilisées :
F1=A et F2=A+B, avec A une fréquence dans le domaine optique (typiquement entre 50 et 500 THz) et B une fréquence hyperfréquence (typiquement entre 0 et 5 THz).

Dans le cas précis suivant : A=195 THz et B est inclus entre 0 et 20 GHz.

Les deux ondes peuvent être générées par un laser bifréquence et être croisées en polarisation en entrée du discriminateur. L'entrée du discriminateur est avantageusement fibrée et à maintien de polarisation.

L'une des voies comporte un modulateur de phase en niobate de lithium qui assure le rôle de délai supplémentaire accordable biréfringent.

Les deux voies comportent des polariseurs orientés à 45° des axes correspondant aux deux ondes optiques. Après les polariseurs, l'architecture reste fibrée.

Les moyens pour générer un retard comprennent une ligne à retard en fibre optique permettant de générer un retard de 0,5 µs réalisé à l'aide de 100 m de fibre optique.

Les moyens pour la comparaison de phase de modulation 5 comprennent : deux photodiodes fibrées rapides, deux amplificateurs hyperfréquences et un mélangeur hyperfréquence.

La fréquence de battement intiale B est de 4 GHz et le filtre basse fréquence est réalisé à l'aide de composants analogiques (bande de boucle de l'ordre de 4 MHz).

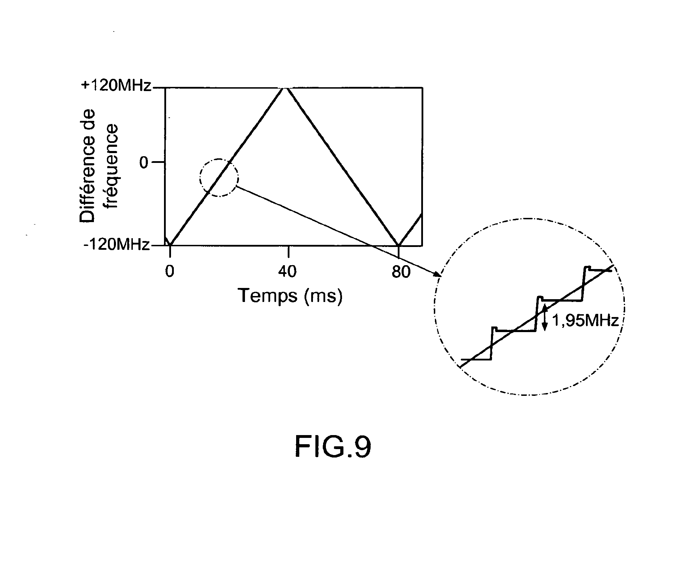

Le balayage en fréquence est réalisé selon une fonction de type celle illustrée en figure 8b, c'est-à-dire avec une fonction « en escalier » par pas de 1.95 MHz (1/τ) sur une plage de 245 MHz (129 fréquences explorées) comme illustré plus précisément en figure 9. On obtient des taux de chirp pouvant excéder 2 MHz/µs.

## Revendications

1. Dispositif opto-électronique de discrimination de fréquence comportant :
- une entrée pour un couple d'ondes optiques comportant une première onde à une première fréquence (F₁) et une seconde onde à une seconde fréquence (F₂), lesdites ondes n'interférant pas ;
- des moyens (2) pour répartir en un premier bras (V_{OA}) et un second bras (V_{OB}) le couple d'ondes optiques à la première fréquence et à la seconde fréquence ;
- des moyens (91, 92) pour faire interférer dans chaque bras la première onde optique et la seconde onde optique, lesdits moyens permettant de définir dans chacun des bras, une zone de non-interférence, en amont desdits moyens (91, 92) pour faire interférer, dite amont (Zni) et une zone d'interférence (Zi), en aval desdis moyens (91, 92) pour faire interférer, dite aval dans laquelle est générée une phase de battement à une fréquence de battement (F₁-F₂) entre les première et seconde ondes optiques qui interférèrent;
- des moyens (31,32) pour générer un délai sur au moins l'un des deux bras en zone d'interférence ;
- des moyens opto-électroniques (5,51,71,72) pour comparer les phases de battement des deux ondes en extrémité de bras fournissant un signal électronique ou optique comparateur ;
**caractérisé en ce que** ledit dispositif comporte en outre
- des moyens (41,42) pour générer un délai supplémentaire accordable sur l'une des première ou seconde ondes optiques en zone de non interférence d'au moins un des deux bras ;
la première onde optique et la seconde onde optique ne coïncidant pas spatialement en entrée dudit dispositif de manière à ne pas interférer, le dispositif comportant des moyens (V_{OAN}, V_{OBN}) pour créer un décalage spatial entre la première et la seconde onde optique dans la zone de non-interférence (Zni).

2. Dispositif opto-électronique de discrimination de fréquence selon la revendication 1, **caractérisé en ce qu'**il comprend des moyens d'asservissement (6) de la première et/ou la seconde fréquence à partir dudit signal électronique comparateur.

3. Dispositif opto-électronique de discrimination de fréquence selon l'une des revendications 1 à 2, **caractérisé en ce que** les moyens pour générer un délai supplémentaire sont présents sur un des premier ou second bras.

4. Dispositif opto-électronique de discrimination de fréquence selon l'une des revendications 1 à 3, **caractérisé en ce qu'**il comprend des premiers moyens (41) pour générer un délai supplémentaire présents sur le premier bras et des seconds moyens (42) pour générer un délai supplémentaire présents sur le second bras.

5. Dispositif opto-électronique de discrimination de fréquence selon l'une des revendications 1 à 4, **caractérisé en ce que** les moyens pour générer un délai supplémentaire comprennent un élément piezoélectrique permettant de changer la longueur d'une ligne à retard en fibre optique.

6. Dispositif opto-électronique de discrimination de fréquence selon l'une des revendications 1 à 4, **caractérisé en ce que** les moyens pour générer un délai supplémentaire comprennent un élément piezoélectrique permettant de changer la longueur d'une ligne à retard en espace libre.

7. Dispositif opto-électronique de discrimination de fréquence selon l'une des revendications 1 à 4, **caractérisé en ce que** les moyens pour générer un délai supplémentaire comprennent un modulateur de phase sur au moins l'un des bras.

8. Dispositif opto-électronique de discrimination de fréquence selon l'une des revendications 1 à 4, **caractérisé en ce que** les moyens pour générer un délai supplémentaire comprennent un élément à biréfringence accordable sur au moins l'un des bras.

9. Dispositif opto-électronique de discrimination de fréquence selon la revendication 1 à 8, **caractérisé en ce que** le premier et/ou le second bras comprennent en outre un polariseur.

10. Dispositif opto-électronique de discrimination de fréquence selon l'une des revendications 1 à 9, **caractérisé en ce que** les moyens opto-électroniques (5) pour comparer lesdites première et seconde phases de battement des deux extrémités de bras fournissant un signal de comparaison comportent un comparateur de phase de modulation.

11. Dispositif opto-électronique de discrimination de fréquence selon la revendication 10, **caractérisé en ce que** le comparateur de phase de modulation comprend deux photodiodes (71,72) recevant chacune le signal provenant de chacun des premier et second bras et un mélangeur électronique (51).

## Patentansprüche

1. Optoelektronische Vorrichtung zur Frequenzdiskriminierung, die Folgendes umfasst:
- einen Eingang für ein Paar optische Wellen, die eine erste Welle mit einer ersten Frequenz (F₁) und eine zweite Welle mit einer zweiten Frequenz (F₂) umfassen, wobei die Wellen nicht interferieren;
- Mittel (2) zum Unterteilen des optischen Wellenpaares in einen ersten Schenkel (V_{OA}) und einen zweiten Schenkel (V_{OB}) mit der ersten Frequenz und mit der zweiten Frequenz;
- Mittel (91, 92), um zu bewirken, dass in jedem Schenkel die erste optische Welle und die zweite optische Welle interferieren, wobei es die Mittel in jedem der Schenkel zulassen, eine Nicht-Interferenzzone, stromaufwärtige Zone (Zni) genannt, stromaufwärts von den Interferenzmitteln (91, 92) und eine Interferenzzone (Zi), stromabwärtige Zone genannt, stromabwärts von den Interferenzmitteln (91, 92) zu definieren, wobei eine Schwebungsphase auf einer Schwebungsfrequenz (F₁-F₂) zwischen der ersten und zweiten interferierenden optischen Welle erzeugt wird;
- Mittel (31, 32) zum Erzeugen einer Verzögerung auf wenigstens einem der beiden Schenkel in der Interferenzzone;
- optoelektronische Mittel (5, 51, 71, 72) zum Vergleichen der Schwebungsphasen der beiden Wellen am Schenkelende, die ein elektronisches oder optisches Vergleichssignal bereitstellen;
**dadurch gekennzeichnet, dass** die Vorrichtung ferner Folgendes umfasst:
- Mittel (41, 42) zum Erzeugen einer zusätzlichen einstellbaren Verzögerung auf der ersten oder der zweiten optischen Welle in der Nicht-Interferenzzone von wenigstens einem der zwei Schenkel;
wobei die erste optische Welle und die zweite optische Welle räumlich nicht am Eingang der Vorrichtung zusammenfallen, so dass sie nicht interferieren, wobei die Vorrichtung Mittel (V_{OAN}, V_{OBN}) zum Erzeugen eines räumlichen Versatzes zwischen der ersten und zweiten optischen Welle in der Nicht-Interferenzzone (Zni) umfasst.

2. Optoelektronische Vorrichtung zur Frequenzdiskriminierung nach Anspruch 1, **dadurch gekennzeichnet, dass** sie Mittel (6) zum Regeln der ersten und/oder zweiten Frequenz auf der Basis des elektronischen Vergleichssignals umfasst.

3. Optoelektronische Vorrichtung zur Frequenzdiskuminierung nach einem der Ansprüche 1 bis 2, **dadurch gekennzeichnet, dass** die Mittel zum Erzeugen einer zusätzlichen Verzögerung auf dem ersten oder dem zweiten Schenkel vorgesehen sind.

4. Optoelektronische Vorrichtung zur Frequenzdiskriminierung nach einem der Ansprüche 1 bis 3, **dadurch gekennzeichnet, dass** sie auf dem ersten Schenkel vorgesehene erste Mittel (41) zum Erzeugen einer zusätzlichen Verzögerung und auf dem zweiten Schenkel vorgesehene zweite Mittel (42) zum Erzeugen einer zusätzlichen Verzögerung umfasst.

5. Optoelektronische Vorrichtung zur Frequenzdiskriminierung nach einem der Ansprüche 1 bis 4, **dadurch gekennzeichnet, dass** die Mittel zum Erzeugen einer zusätzlichen Verzögerung ein piezoelektrisches Element zum Ändern der Länge einer Verzögerungsleitung durch Lichtwellenleiter umfassen.

6. Optoelektronische Vorrichtung zur Frequenzdiskriminierung nach einem der Ansprüche 1 bis 4, **dadurch gekennzeichnet, dass** die Mittel zum Erzeugen einer zusätzlichen Verzögerung ein piezoelektrisches Element zum Ändern der Länge einer Verzögerungsleitung im freien Raum umfassen.

7. Optoelektronische Vorrichtung zur Frequenzdiskriminierung nach einem der Ansprüche 1 bis 4, **dadurch gekennzeichnet, dass** die Mittel zum Erzeugen einer zusätzlichen Verzögerung einen Phasenmodulator auf wenigstens einem der Schenkel umfassen.

8. Optoelektronische Vorrichtung zur Frequenzdiskriminierung nach einem der Ansprüche 1 bis 4, **dadurch gekennzeichnet, dass** die Mittel zum Erzeugen einer zusätzlichen Verzögerung ein Doppelbrechungselement umfassen, das auf wenigstens einem der Schenkel eingestellt werden kann.

9. Optoelektronische Vorrichtung zur Frequenzdiskriminierung nach einem der Ansprüche 1 bis 8, **dadurch gekennzeichnet, dass** der erste und/oder zweite Schenkel ferner einen Polarisator umfasst/umfassen.

10. Optoelektronische Vorrichtung zur Frequenzdiskriminierung nach einem der Ansprüche 1 bis 9, **dadurch gekennzeichnet, dass** die optoelektronischen Mittel (5) zum Vergleichen der ersten und zweiten Schwebungsphase der beiden Schenkelenden, die ein Vergleichssignal bereitstellen, einen Phasenmodulationskomparator umfassen.

11. Optoelektronische Vorrichtung zur Frequenzdiskriminierung nach Anspruch 10, **dadurch gekennzeichnet, dass** der Phasenmodulationskomparator zwei Fotodioden (71, 72), die jeweils das von jedem des ersten und des zweiten Schenkels stammende Signal empfangen, und einen elektronischen Mixer (51) umfasst.

## Claims

1. An optoelectronic device for frequency discrimination comprising:
- an input for a pair of optical waves comprising a first wave at a first frequency (F₁) and a second wave at a second frequency (F₂), said waves not interfering;
- means (2) for separating said pair of optical waves into a first branch (V_{OA}) and a second branch (V_{OB}) at the first frequency and at the second frequency;
- means (91, 92) for making said first optical wave and said second optical wave interfere in each branch, said means allowing, in each of said branches, a zone of non-interference, called the upstream zone (Zni), to be defined upstream of said interference means (91, 92), and a zone of interference (Zi), called the downstream zone, which is to be defined downstream of said interference means (91, 92) and in which a beat phase is generated at a beat frequency (F₁-F₂) between said first and second interfering optical waves;
- means (31, 32) for generating a delay on at least one of said two branches in a zone of interference;
- optoelectronic means (5, 51, 71, 72) for comparing the beat phases of said two waves at the end of the branch providing an electronic or optical comparison signal;
**characterised in that** said device further comprises:
- means (41, 42) for generating an additional tuneable delay on one of said first or second optical waves in the zone of non-interference of at least one of said two branches;
said first optical wave and said second optical wave not spatially coinciding at the input of said device so as not to interfere, said device comprising means (V_{OAN}, V_{OBN}) for creating a spatial offset between said first and said second optical wave in said zone of non-interference (Zni).

2. The optoelectronic device for frequency discrimination according to claim 1, **characterised in that** it comprises means (6) for controlling said first and/or said second frequency from said electronic comparison signal.

3. The optoelectronic device for frequency discrimination according to any one of claims 1 to 2, **characterised in that** said means for generating an additional delay are present on one of said first or second branches.

4. The optoelectronic device for frequency discrimination according to any one of claims 1 to 3, **characterised in that** it comprises first means (41) for generating an additional delay that are present on said first branch and second means (42) for generating an additional delay that are present on said second branch.

5. The optoelectronic device for frequency discrimination according to any one of claims 1 to 4, **characterised in that** said means for generating an additional delay comprise a piezoelectric element for changing the length of a delay line in optical fibre.

6. The optoelectronic device for frequency discrimination according to any one of claims 1 to 4, **characterised in that** said means for generating an additional delay comprise a piezoelectric element for changing the length of a delay line in free space.

7. The optoelectronic device for frequency discrimination according to any one of claims 1 to 4, **characterised in that** said means for generating an additional delay comprise a phase modulator on at least one of said branches.

8. The optoelectronic device for frequency discrimination according to any one of claims 1 to 4, **characterised in that** said means for generating an additional delay comprise a bireflingence element that can be tuned on at least one of said branches.

9. The optoelectronic device for frequency discrimination according to any one of claims 1 to 8, **characterised in that** said first and/or said second branch further comprise(s) a polariser.

10. The optoelectronic device for frequency discrimination according to any one of claims 1 to 9, **characterised in that** said optoelectronic means (5) for comparing said first and second beat phases of the two ends of branches that provide a comparison signal comprise a phase modulation comparator.

11. The optoelectronic device for frequency discrimination according to claim 10, **characterised in that** said phase modulation comparator comprises two photodiodes (71, 72) each receiving the signal originating from each of said first and second branches, and an electronic mixer (51).
